# DEMANDE DE BREVET EUROPEEN

(11) **EP 1 028 532 A1**
(43) Date de publication de la demande: **16.08.2000**
(21) Numéro de dépôt: 00400140.0
(22) Date de dépôt: 20.01.2000
(51) Int. Cl.: H03M 11/20

(54) **Dispositif de gestion d'un clavier à touches**

(30) Priorité: 11.02.1999 FR 9901608
(71) Demandeur: ALCATEL, 75008 Paris (FR)
(72) Inventeur: Attimont, Luc, 78100 Saint Germain en Laye (FR); Bodin, Jannick, 92380 Garches (FR)
(74) Mandataire: Lamoureux, Bernard

(57) **Abrégé**

Un dispositif de gestion d'un clavier à touches disposées chacune à l'intersection d'un conducteur de ligne et d'un conducteur de colonne comprend au moins un circuit de temporisation 32 par conducteur de ligne w2. Chaque circuit de temporisation 32 est connecté entre au moins un conducteur de colonne c2 et un conducteur de ligne w2. Ces moyens de temporisation permettent de restituer sur le conducteur de ligne associé w2, une information précédemment envoyée sur un conducteur de ligne w1 lorsque la touche T₁₂ à l'intersection de ce dernier conducteur de ligne w1 et du conducteur de colonne c2 associé au-dit circuit de temporisation 32 est enfoncée.

## Description

La présente invention concerne un dispositif de gestion d'un clavier à touches, tel qu'un clavier de terminal informatique ou de télécommunication.

Les claviers à touches sont habituellement organisés matriciellement en lignes et en colonnes. Chaque touche du clavier est physiquement placée à une intersection d'un conducteur de ligne et d'un conducteur de colonne, en sorte qu'une pression sur ladite touche connecte électriquement le conducteur de ligne et le conducteur de colonne, généralement par une diode.

Un dispositif de gestion d'un tel clavier à touches doit contrôler tous les conducteurs de lignes et tous les conducteurs de colonnes pour assurer la scrutation du clavier, c'est à dire, pour déterminer sur quelle(s) touche(s) un utilisateur a appuyé.

En général, le dispositif de génération reste en mode de veille jusqu'à détecter qu'une touche est enfoncée et déclenche alors un cycle complet de balayage du clavier. En mode de veille, des niveaux continus différents sont imposés sur les conducteurs de ligne et les conducteurs de colonne. Ainsi, lorsqu'un utilisateur appuie sur une touche, cela a pour effet de ramener le niveau de tension de la colonne sur la ligne correspondante, ce qui est détecté par le dispositif de gestion.

Si la matrice comprend n conducteurs de lignes et m conducteurs de colonnes, l'interface du dispositif de gestion doit comprendre autant de ports d'entrées/sorties correspondants, soit n.m.

Si le nombre de touches est très important, il faut donc prévoir un dispositif de gestion comprenant une interface disposant d'un grand nombre de ports d'entrées/sorties, ce qui est coûteux. En outre, selon les applications concernées, cette interface peut-être physiquement située loin du clavier à touches. Il faut donc tirer beaucoup de fils et sur une certaine longueur, ce qui est aussi très coûteux.

Dans l'invention, on cherche donc à réduire le nombre de fils nécessaires à la gestion d'un clavier à touches.

Un objet de la présente invention est ainsi un dispositif de gestion d'un tel clavier utilisant un nombre limité de ports d'entrées/sorties.

Un autre objet de l'invention est un dispositif de gestion d'un clavier dont le cycle de scrutation est particulièrement court permettant ainsi l'utilisation du dispositif de gestion, en dehors des cycles de scrutation du clavier, pour commander ou lire des éléments à commande d'entrée/sortie lentes.

En effet, dans les applications utilisant des claviers, on trouve d'autres équipements électroniques remplissant des fonctions diverses. Certains de ces équipements peuvent comprendre des éléments à commande d'entrée/sortie lentes par rapport à la logique de gestion d'un clavier à touches selon l'invention. Ce sont par exemple des commandes de commutation de relais, pour actionner un équipement, par exemple un climatisateur, ou encore des commandes d'allumage de diodes électroluminescentes, ou de mesures fournies par des capteurs divers de température ou autres. La liste n'est pas exhaustive.

Le dispositif de gestion selon l'invention utilisé pour le clavier et des éléments à commande d'entrée/sortie lente permet ainsi de réduire les moyens de gestion nécessaires dans un système électronique complexe et surtout de réduire le nombre et la longueur des fils à tirer entre les divers équipements de ce système.

Telle que caractérisée, l'invention concerne donc un dispositif de gestion par n conducteurs de ligne d'un clavier à touches, ces touches étant chacune disposées à l'intersection d'un conducteur de ligne et d'un conducteur de colonne. Selon l'invention, ce dispositif comprend au moins un circuit de temporisation d'une information par conducteur de ligne, chacun connecté en entrée à au moins un conducteur de colonne et en sortie à un conducteur de ligne, pour restituer sur le conducteur de ligne associé, une information préalablement envoyée sur l'un des conducteurs de ligne lorsque la touche à l'intersection de ce dernier conducteur de ligne et du conducteur de colonne associé au-dit circuit de temporisation est enfoncée

L'invention concerne aussi un dispositif de gestion d'un clavier à touches apte à fournir sur la même interface que celle du clavier, des signaux de gestion d'entrées/sorties de fréquence plus lente que celle des signaux de gestion du clavier à touches.

D'autres caractéristiques et avantages de l'invention sont décrits dans la description suivante, faite à titre indicatif et nullement limitatif et en référence aux dessins annexés dans lesquels :
la figure 1 est un schéma-bloc général d'un premier mode de réalisation d'un dispositif de gestion d'un clavier à touches selon l'invention;
la figure 2a représente schématiquement un dispositif de gestion utilisant des circuits de temporisation à élément à retard ;
la figure 2b représente schématiquement un dispositif de gestion utilisant des circuits de temporisation à mémoire;
la figure 3 est un organigramme de fonctionnement correspondant au schéma de la figure 1;
la figure 4 est un schéma-bloc d'un deuxième mode de réalisation d'un dispositif de gestion d'un clavier à touches selon l'invention;
la figure 5 est un organigramme de fonctionnement correspondant au schéma de la figure 4;
la figure 6 est un schéma-bloc d'un troisième mode de réalisation d'un dispositif de gestion d'un clavier selon l'invention;
la figure 7 représente schématiquement un exemple de réalisation d'un élément de tirage fort;
les figures 8, 9 et 10 représentent schématiquement des exemples d'éléments de tirage faibles;
la figure 11 est un diagramme représentant les cycles de scrutation et de veille pour la gestion du clavier ainsi que les variations de niveau sur un conducteur de ligne selon qu'il est utilisé dans un cycle de scrutation ou dans un cycle de gestion d'une entrée ou d'une sortie lente; et
la figure 12 est un schéma-bloc d'un dispositif de gestion selon l'invention pour la commande ou la lecture d'entrées/sorties lentes.

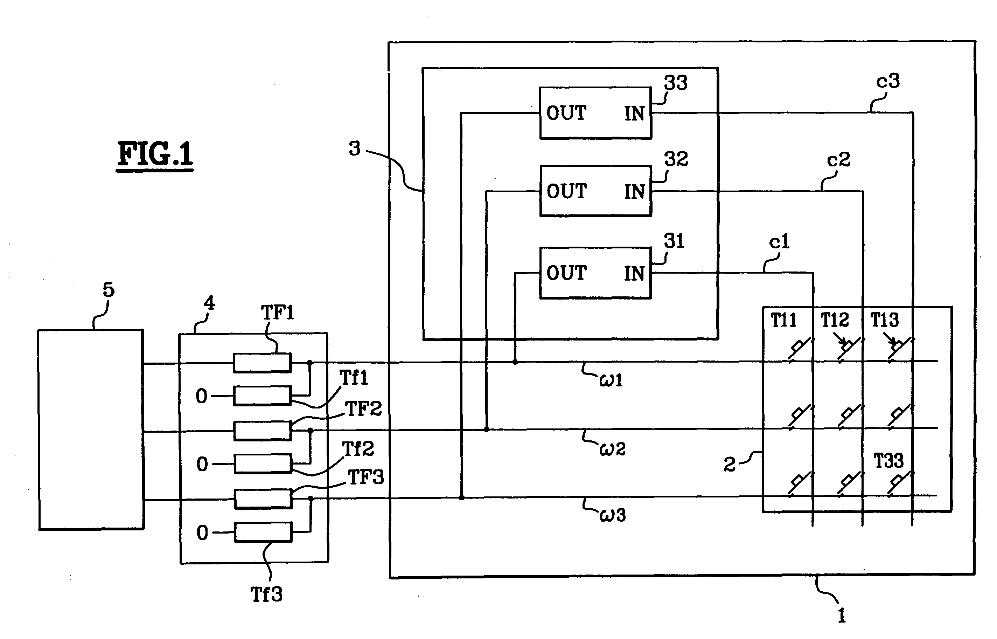

La figure 1 représente un premier exemple de réalisation d'un dispositif de gestion d'un clavier à touches selon l'invention.

Il comprend un clavier 1 à touches disposées chacune à l'intersection d'un conducteur de ligne et d'un conducteur de colonne d'une matrice 2.

Dans l'exemple, la matrice comprend 3 conducteurs de lignes w1, w2, w3 et 3 conducteurs de colonnes c1, c2, c3. L'homme du métier saura généraliser le principe de l'invention à une matrice à n conducteurs de ligne et n conducteurs de colonne avec n² touches au maximum (une à chaque intersection). Dans la suite, on a n=3 et on suppose que l'on a une touche à chaque intersection, soit 9 touches. Ces touches, T₁₁ à T₃₃ dans l'exemple, sont schématiquement représentées par un bouton poussoir, qui permet de connecter le conducteur de ligne au conducteur de colonne, lorsque l'on exerce une pression dessus, c'est à dire, lorsqu'un utilisateur appuie dessus. Dans la suite l'expression simplifiée "touche enfoncée" signifie qu'un utilisateur appuie dessus.

Le dispositif de gestion selon le premier mode de réalisation de l'invention comprend des moyens 3 de temporisation d'une information. Ces moyens de temporisation comprennent n circuits de temporisation, chacun connecté entre un conducteur de colonne et un conducteur de ligne. Dans l'exemple, un premier circuit de temporisation 31 a ainsi son entrée I 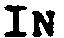 connectée au premier conducteur de colonne c1 et sa sortie O 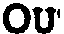 connectée au premier conducteur de ligne w1. Un deuxième circuit de temporisation 32 a son entrée I connectée au deuxième conducteur de colonne c2 et sa sortie O connectée au deuxième conducteur de ligne w2. Un troisième circuit de temporisation 33 a son entrée I connectée au troisième conducteur de colonne c3 et sa sortie O connectée au troisième conducteur de ligne w3. Dans l'exemple, chaque circuit de temporisation est connecté à une extrémité d'un conducteur de colonne. Mais la connexion peut-être réalisée en un point quelconque de chaque conducteur de colonne, par exemple, au milieu de celui-ci.

Le principe de l'invention est d'envoyer une intonation sur chaque conducteur de ligne à un instant t0 et de venir voir si à un instant t0+Dt, on récupère cette information sur l'un des conducteurs de ligne, via un circuit de temporisation. En effet, si un utilisateur du clavier appuie sur une touche du conducteur de ligne sur lequel on a envoyé une intonation, il renvoie cette information vers le circuit de temporisation connecté au conducteur de colonne correspondant, qui la restitue sur le conducteur de ligne associé.

Le dispositif de gestion selon l'invention permet alors, à partir d'un balayage sur les seuls conducteurs de ligne, de gérer l'état du clavier.

Les circuits de temporisation sont de préférence prévus dans le clavier. Mais ils peuvent très bien être externes au clavier. Dans ce cas, pour réduire la longueur des connexions, on le placera à proximité immédiate du clavier, si c'est possible.

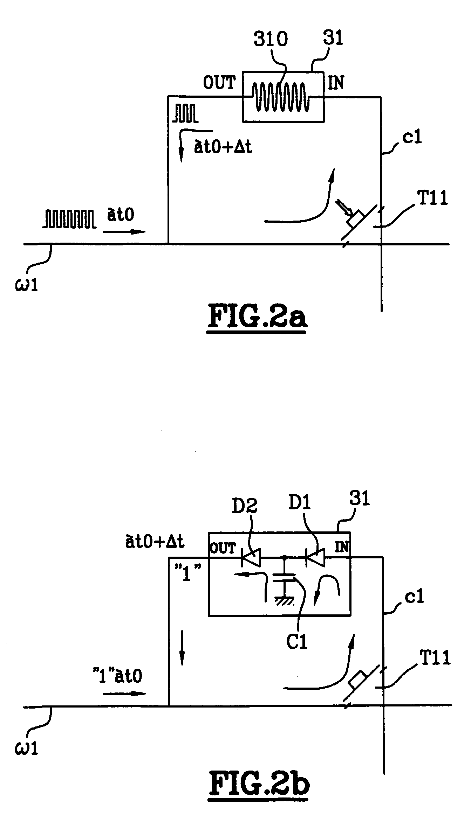

Dans un exemple de réalisation pratique représenté sur la figure 2a, les circuits de temporisation 31 à 33 sont des circuits à retard, par exemple des lignes à retards. La figure 2a représente ainsi le circuit de temporisation 31, connecté entre le conducteur de colonne c1 et le conducteur de ligne w1, dans lequel une ligne à retard est symbolisée par un fil en serpentin 310.

Si on envoie une forme d'onde, par exemple une onde sinusoïdale haute fréquence sur le conducteur de ligne w1, dans le cas où la touche T₁₁ associée à ce conducteur est enfoncée, cette forme d'onde est restituée après un certain retard Dt sur le conducteur de ligne w1, par le circuit de temporisation 31. Si c'est la touche T₁₂ qui est enfoncée , la forme d'onde envoyée sur le conducteur w1 est restituée sur le conducteur de ligne w2, par le circuit de temporisation 32 (voir figure 1).

Dans un autre exemple de réalisation pratique représenté sur la figure 2b, les circuits de temporisation 31 à 33 sont des circuits de temporisation à mémoire.

Ces circuits de temporisation à mémoire sont par exemple de type capacitifs, c'est à dire utilisant la charge et la décharge d'un condensateur pour mémoriser deux niveaux logiques possibles, "0" et "1". Un circuit de temporisation à mémoire de ce type est schématiquement représenté sur la figure 2b. Il comprend dans l'exemple deux diodes D1 et D2 connectées en série et en direct entre l'entrée I et la sortie O. Un condensateur C1 a une électrode (armature) connectée au point milieu A entre les deux diodes, et l'autre électrode reliée à la masse électrique.

Un tel circuit de temporisation à mémoire est tel que, si on applique un niveau logique haut, "1", en entrée, la diode D1 va permettre la charge du condensateur C1. Le noeud A ( le point milieu de D1-D2) monte à 1. Si maintenant on applique un niveau logique bas, "0" sur la sortie O, le condensateur va se décharger via la diode D2. Le noeud A passe à zéro si on applique le niveau "0" en sortie O suffisamment longtemps. Ce niveau "0" qui permet l'initialisation du circuit de temporisation à mémoire est complémentaire de l'information que l'on peut envoyer sur l'entrée I et restituer en sortie O.

Avec un tel exemple de réalisation d'un circuit de temporisation à mémoire, le principe de fonctionnement du dispositif de gestion selon l'invention devient alors le suivant, pour déterminer quelles touches d'un conducteur de ligne wi donné sont enfoncées (s'il y en a) :

Dans une première étape, on ré-initialise tous les circuits de temporisation à mémoire 31 à 33. Pour cela, on tire fortement tous les conducteurs de ligne w1 à w3 au niveau d'initialisation, "0" dans l'exemple. On a donc "0" en sortie OUT de tous les circuits de temporisation 31 à 33.

Dans une deuxième étape, on envoie l'information "1" sur le conducteur de ligne wi déterminé, tandis que l'on maintient les autres conducteurs de ligne au niveau d'initialisation (en les tirant faiblement à ce niveau "0"). Pour envoyer l'information sur le conducteur wi déterminé, on tire ce conducteur très fortement au niveau correspondant à l'information, "1" dans l'exemple.

Les conducteurs de colonne sont normalement maintenus à la masse électrique du clavier, par la diode D1 et le condensateur C1 du circuit de temporisation auquel ils sont connectés.

Pour les conducteurs de colonne dont les touches correspondant au conducteur de ligne wi ne sont pas enfoncées, les circuits de temporisation correspondant restent dans l'état imposé par l'étape de ré-initialisation, c'est à dire à "0" dans l'exemple.

Si une touche du conducteur wi est enfoncée, le conducteur de ligne wi et le conducteur de colonne correspondant sont reliés électriquement. On retrouve donc le "1" fort du conducteur de ligne wi sur l'entrée Idu circuit de temporisation. Le condensateur C1 de ce circuit va donc se charger.

Cette étape d'envoi de l'information dure un temps minimum déterminé pour permettre une charge suffisante du condensateur, en sorte qu'à la fin de cette étape, le circuit de temporisation contienne l'information désirée, "1" dans l'exemple.

Dans une troisième étape, que l'on appelle étape de lecture, on vient voir si on lit en retour cette information sur un ou des conducteurs de ligne.

Pour cela, on tire faiblement tous les conducteurs de ligne sans exception, à la valeur d'initialisation, "0". Les circuits de temporisation qui ont reçu un "1" vont restituer ce "1" sur leur sortie OUT et l' imposer fortement sur le conducteur de ligne correspondant. Les éléments qui sont restés à "0" vont confirmer ce niveau sur les conducteurs de ligne correspondants.

Ainsi, la lecture du niveau des conducteurs de ligne permet de déterminer quelles touches du conducteur de ligne wi sur lequel on a envoyé l'information sont enfoncées. Le balayage complet du clavier, en appliquant successivement chacune des trois étapes à chacun des conducteurs de ligne permet de déterminer l'état de ce clavier.

Dans ce mode de réalisation de l'invention, le dispositif de gestion comprend donc des moyens 4 de tirage des conducteurs de ligne, généralement appelés*drivers* selon la terminologie anglo-saxonne, pour assurer le tirage faible ou fort de ces conducteurs lors des différentes étapes de ré-initialisation, d'envoi de l'information et de lecture. Ces moyens de tirage sont typiquement commandés par un module central de commande non représenté (logique câblée -avec horloge -, micro-ordinateur ou micro-processeur) via une interface d'entrée/sortie 5 de ce module ou d'un micro-contrôleur piloté par lui, interface représentée sur la figure 1.

Ces moyens de tirage 4 comprennent un dispositif de tirage fort TFᵢ pour forcer chaque conducteur de ligne associé au niveau d'initialisation "0" dans les étapes de ré-initialisation ou au niveau de l'information "1" dans l'étape d'envoi de l'information sur un conducteur de ligne. En pratique, on a un tel dispositif de tirage fort par conducteur de ligne du clavier. Il faut entendre par tirage à "0", tirage au niveau de la masse électrique du dispositif de gestion et par tirage à "1", tirage au niveau d'une alimentation logique positive V 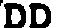 du dispositif de gestion.

Les moyens de tirage 4 comprennent en outre un dispositif de tirage faible Tfᵢ, pour tirer les conducteurs de ligne au niveau d'initialisation dans les étapes d'envoi de l'information et de lecture. En pratique, on peut avoir un dispositif de tirage faible pour un ou plusieurs conducteurs de ligne.

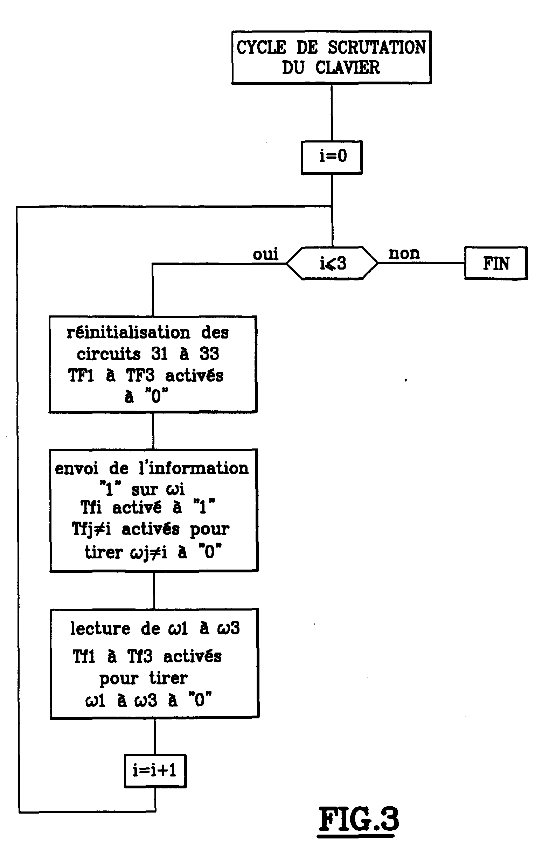

Un organigramme détaillé de fonctionnement correspondant est représenté sur la figure 3.

Pour lire l'état enfoncé ou non des touches associées à un conducteur de ligne donné, par exemple w1, le dispositif de gestion selon l'invention applique donc successivement les étapes du cycle de scrutation suivantes:
l'étape de ré-initialisation, dans laquelle il active tous les éléments de tirage fort TF1, TF2 et TF3, pour forcer la valeur d'initialisation "0" sur tous les conducteurs de ligne w1, w2 et w3, afin de ré-initialiser tous les circuits de temporisation 31 à 33 par leur sortie O.
l'étape d'envoi de l'information, dans laquelle il active l'élément de tirage fort T1 du conducteur de ligne w1 pour le forcer au niveau de l'information, "1", et les éléments de tirage faible Tf2 et Tf3 pour tirer les autres conducteurs de ligne, w2 et w3 à la valeur d'initialisation, "0".
l'étape de lecture dans laquelle le dispositif de gestion active tous les éléments de tirage faible Tf1, Tf2 et Tf3, pour tirer tous les conducteurs de ligne au niveau d'initialisation "0". Cette étape de lecture doit être en pratique réalisée dans un intervalle de temps déterminé, court, fonction des caractéristiques du circuit de temporisation.

Si les touches sur lesquelles appuie l'utilisateur sont les touches T₁₂ et T₁₃, comme représenté schématiquement sur la figure 1 par une flèche au-dessus de ces touches, les circuits de temporisation correspondants 32 et 33 auront changé d'état : ils seront passés à "1". Dans ce cas, le dispositif de gestion lit donc un "0" sur le conducteur de ligne w1 (301 contient "0") et un "1" sur les deux conducteurs de ligne w2 et w3 (32 et 33 contiennent "1"). Il en déduit que les touches T₁₂ et T₁₃ sont enfoncées et garde cette information.

Il passe ensuite au conducteur de ligne suivant, et ainsi de suite, jusqu'à avoir scruté tous les conducteurs de ligne du clavier.

On notera que l'étape de ré-initialisation peut ne pas être nécessaire, selon le type de circuits de temporisation utilisés, par exemple, si on utilise des lignes à retard.

On peut très bien utiliser des circuits de temporisation à mémoire duals, c'est à dire dont les niveaux d'initialisation et d'information sont complémentaires de ceux du circuit de temporisation à mémoire précédemment décrit. Un tel circuit de temporisation est par exemple obtenu en inversant l'entrée I et l'entrée O du circuit de temporisation à mémoire représenté dans la figure 2b. Par rapport au dispositif de gestion précédemment décrit, il suffit de complémenter tous les niveaux. En particulier, un dispositif de gestion correspondant comprendra des éléments de tirage fort à "0" et à "1" et des éléments de tirage faible à "1".

Le dispositif de gestion selon le premier mode de réalisation de l'invention comprend ainsi n circuits de temporisation à mémoire permettant la gestion d'un clavier par ses n conducteurs de ligne, le clavier comportant n conducteurs de colonne et un maximum de n² touches.

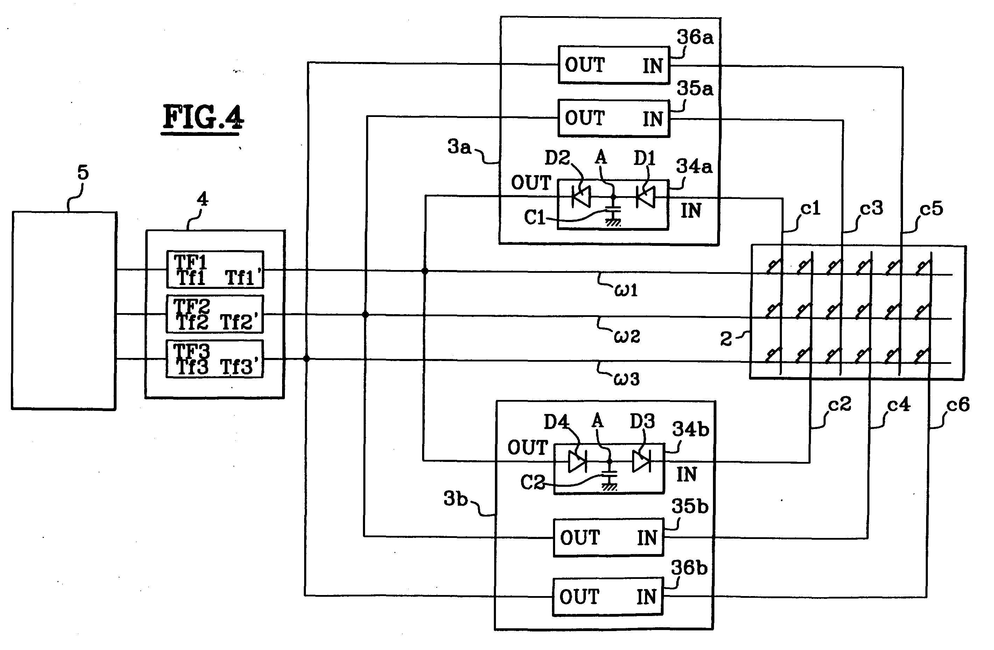

La figure 4 représente un deuxième mode de réalisation d'un dispositif de gestion selon l'invention.

Il permet de gérer deux fois plus de touches que dans le premier mode de réalisation, soit jusqu'à 2.n² touches, à partir du même nombre n de conducteurs de ligne, en utilisant 2.n circuits de temporisation (au lieu de n circuits de temporisation dans le premier mode de réalisation). Le clavier comporte alors 2.n colonnes.

Dans ce mode de réalisation de l'invention, on prévoit deux circuits de temporisation d'une information différente par conducteur de ligne, chacun connecté à un conducteur de colonne différent. Les moyens de temporisation 3 comprennent alors un premier groupe 3a de circuits de temporisation d'une première information et un deuxième groupe 3b de circuits de temporisation d'une autre information. Pour simplifier leur représentation sur la figure 4, on a représenté un premier groupe en haut, et le deuxième groupe est représenté en bas. Cette disposition géographique n'est utilisée que dans un souci de simplification du dessin. En pratique la disposition physique de ces circuits de temporisation peut être différente (ils peuvent être tous au milieu par exemple). Le premier groupe comprend dans l'exemple trois circuits de temporisation d'une première information 34a, 35a et 36a. Le circuit de temporisation 34a est connecté en entrée I, au conducteur de colonne c1 et en sortie O au conducteur de ligne w1. Le circuit de temporisation 35a est connecté en entrée I, au conducteur de colonne c3, et en sortie O au conducteur de ligne w2. Le circuit de temporisation 36a est connecté en entrée I au conducteur de colonne c5 et en sortie O au conducteur de ligne w3.

Le deuxième groupe 3b comprend dans l'exemple trois circuits de temporisation d'une autre information, 34b, 35b et 36b. Le circuit de temporisation 34b est connecté en entrée I au conducteur de colonne c2 et en sortie O au conducteur de ligne w1. Le circuit de temporisation 35b est connecté en entrée I au conducteur de colonne c4, et en sortie O au conducteur de ligne w2. Le circuit de temporisation 36b est connecté en entrée I, au conducteur de colonne c6, et en sortie O au conducteur de ligne w3.

Sur la figure 4, les deux circuits de temporisation connectés au même conducteur de ligne sont donc connectés à des conducteurs de colonne successifs (34a à c1 et 34b à c2). Il s'agit d'un exemple possible d'implémentation de l'invention, qui est optimisé en terme de longueur de fil de connexion (les circuits de temporisation connectés au même conducteur de ligne étant connectés à deux conducteurs de colonne physiquement les plus proches. Ce n'est évidemment pas le seul.

Le principe général de l'invention est alors, pour chaque conducteur de ligne d'envoyer la première information sur le conducteur de ligne, et de venir ensuite lire tous les conducteurs de ligne pour voir si cette première information a été restituée par un ou des circuits de temporisation du premier groupe ; puis d'envoyer la deuxième information sur le conducteur de ligne et de venir ensuite lire tous les conducteurs de ligne pour voir si cette deuxième information a été restituée par un ou plusieurs circuits de temporisation du deuxième groupe.

Le deuxième mode de réalisation avec deux groupes de circuit de temporisation d'une information différente, permet, à partir d'un même nombre n de conducteurs de ligne, de gérer un clavier comprenant deux fois plus de colonnes. Ce principe peut-être généralisé à n groupes de circuits de temporisation d'une information différente. Par exemple, s'agissant de circuits de temporisation à lignes à retard, on peut leur associer un filtre, en sorte qu'il ne prenne en compte qu'une information de fréquence donnée (ou dans un intervalle de fréquence donné). On peut alors constituer plusieurs groupes de circuits de temporisation, chaque groupe étant caractérisé par le filtre associé. A partir des n conducteurs de ligne, on peut alors gérer un clavier comportant k.n conducteurs de colonne, k correspondant au nombre de groupe de circuit de temporisation d'une information différente constitués.

Sur la figure 4, on a plus particulièrement représenté un dispositif de gestion utilisant des circuits de temporisation à mémoire ne pouvant prendre que deux états logiques "0" ou "1".

Le premier groupe 3a comprend les circuits de temporisation d'une information "1" et le groupe 3b comprend les circuits de temporisation de l'information duale "0".

Un exemple de réalisation du circuit de temporisation 34a et du circuit de temporisation dual 34b est donné. Le circuit 34a correspond au schéma représenté sur la figure 2b déjà décrite. Le circuit dual 34b comprend deux diodes en série, D3 et D4, connectées en inverse entre l'entrée I et la sortie O et un condensateur C2 connecté entre le point milieu B entre les deux diodes et la masse. Quand on applique "0" en entrée I, la diode D3 permet la décharge du condensateur C2. Le noeud B au point milieu passe à "0": c'est le niveau d'information que peut temporiser ce circuit 34b. La diode D4 permet l'initialisation de ce circuit 34b par la charge du condensateur C2 lorsque l'on a un "1" suffisamment fort appliqué sur la sortie Opendant un temps suffisant.

Pour gérer les circuits de temporisation et leurs duals, les moyens de tirage 4 comprennent les éléments de tirage fort à "1" et à "0" déjà vus, TF₁, TF₂ et TF₃ et des éléments de tirage faible à "1", notés T_{f1'}, T_{f2'} et T_{f3'}, en plus des éléments de tirage faible à "0" déjà vus T_{f1}, T_{f2} et T_{f3}. On peut avantageusement utiliser à la place d'un élément de tirage faible à "0" et d'un élément de tirage faible à "1", un seul élément dynamique de tirage faible à "0" ou à "1". Un exemple pratique d'un tel élément sera décrit plus loin.

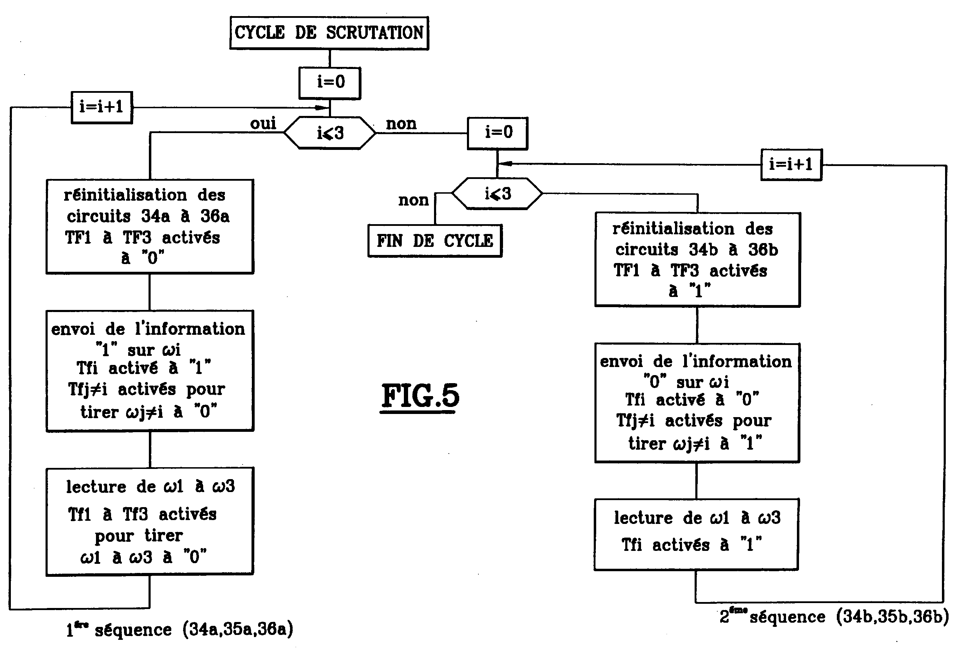

Le cycle de scrutation pour un conducteur de ligne wi va alors se dérouler en deux temps : dans un premier temps, on ne s'intéresse qu'aux circuits de temporisation du premier type, par exemple, puis à ceux du deuxième type. En d'autres termes, dans un premier temps, on lit la moitié des touches d'un conducteur de lignes au moyen des circuits de temporisation d'un premier groupe et dans un deuxième temps, on lit l'autre moitié des touches au moyen des circuits de temporisation du deuxième groupe. On peut faire cette lecture des deux moitiés de touches conducteur de ligne par conducteur de ligne, en s'intéressant à l'un des deux circuits de temporisation puis à son dual. On peut aussi faire cette lecture en s'intéressant à l'un des groupes, pour la matrice entière puis à l'autre groupe, pour la matrice entière. Un exemple d'organigramme de fonctionnement correspondant à ce dernier choix est représenté sur la figure 5. Il comprend une première séquence d'étapes appliquée successivement à chaque conducteur de lignes. Cette séquence d'étapes correspond à la séquence d'étapes déjà vue en relation avec les figures 1 et 3. Il comprend à sa suite une deuxième séquence d'étapes appliquée successivement à chaque conducteur de ligne. Cette deuxième séquence d'étapes correspond à la séquence duale de la première, les niveaux d'information et d'initialisation étant inversés. On notera que l'ordre des séquences est arbitraire. On pourrait aussi bien commencer par la deuxième séquence et enchaîner avec la première séquence.

Dans le cas des circuits de temporisation à mémoire, on notera que le niveau de l'information envoyé sur un conducteur de ligne, par exemple sur w1, pour les circuits de temporisation d'un groupe, 3a par exemple, correspond au niveau de ré-initialisation pour ce conducteur w1, du circuit de temporisation dual associé à ce conducteur w1, 34b dans l'exemple. Cet élément 34b se retrouve donc initialisé à "1". La même remarque vaut pour tous les circuits de temporisation à mémoire des deux groupes. Mais le fait que, dans une séquence utilisant les circuits de temporisation d'un groupe, les circuits de temporisation de l'autre groupe puissent se retrouver initialisés, ne gêne en rien le bon déroulement de cette séquence. La seule conséquence pratique est que les dispositifs de tirage fart utilisés pour envoyer l'information doivent être dimensionnés suffisamment pour supporter cette contrainte.

D'une manière générale, les étapes de lecture des deux séquences doivent être exécutées rapidement, dans un intervalle de temps déterminé, qui peut-être très court, selon les caractéristiques des circuits de temporisation.

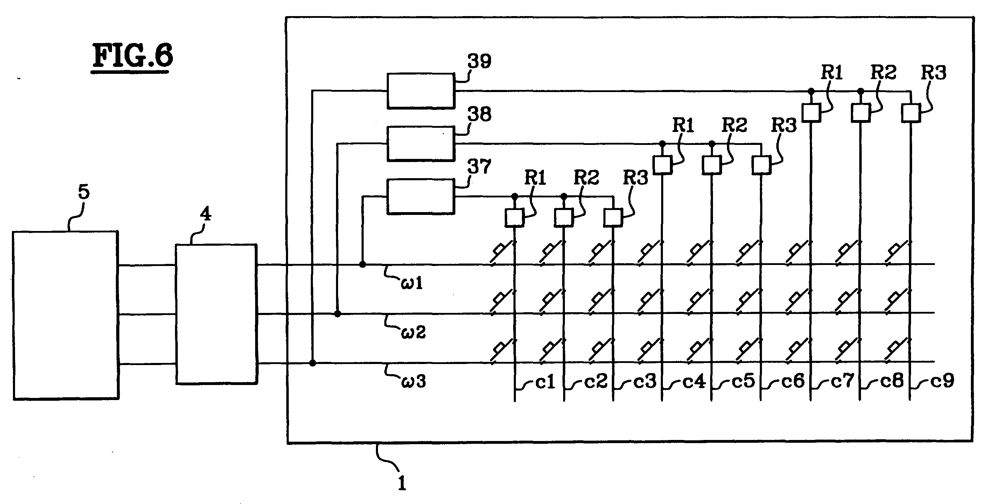

Un troisième mode de réalisation d'un dispositif de gestion selon l'invention est représenté sur la figure 6. Dans ce troisième mode de réalisation, on prévoit qu'un même circuit de temporisation est connecté à plusieurs conducteurs de colonne par un réseau de circuits de sélection. Ce circuit de sélection correspond à une caractéristique de l'information envoyée. Cette caractéristique de l'information envoyée peut-être par exemple sa fréquence, dans le cas des circuits de temporisation à lignes à retard. Dans ce cas, le circuit de sélection est un filtre, avec une bande-passante caractéristique par conducteur de colonne connecté à un circuit de temporisation.

Cette caractéristique de l'information envoyée peut-être sa durée d'application, dans le cas des circuits de temporisation à mémoire. Dans ce cas le circuit de sélection est une résistance. C'est cette application du troisième mode de réalisation selon l'invention qui est plus particulièrement représentée sur la figure 6.

Un même circuit de temporisation est ainsi connecté à plusieurs conducteurs de colonne par un réseau de résistances, avec une résistance de valeur caractéristique pour chaque conducteur de colonne.

Dans l'exemple, chaque circuit de temporisation 37, 38, 39 est connecté à trois conducteurs de colonne. Ainsi le circuit de temporisation 37 est connecté aux trois conducteurs de colonne c1, c2 et c3. Cette connexion se fait par des éléments résistifs, un par conducteur de colonne, la valeur de la résistance étant différente pour chacun de ces conducteurs de colonne. On a donc pour chaque circuit de temporisation un réseau de trois éléments résistifs de valeurs respectives R1, R2, R3 différentes. Par exemple, R1<R2<R3. On notera dors et déjà que ce troisième mode de réalisation selon l'invention peut-être utilisé en combinaison avec le deuxième mode de réalisation de l'invention : dans ce cas, les circuits de temporisation de chacun des groupes sont chacun connectés à plusieurs colonnes, à travers un réseau de résistances associé.

Le principe utilisé ici pour gérer le clavier à touches est basé sur la constante de temps que l'on retrouve sur chaque conducteur de colonne, définie par la capacité équivalente du circuit de temporisation et la résistance équivalente du conducteur de colonne. En effet, selon l'invention, cette constante de temps va être différente pour chacun des conducteurs de colonne associés à un même circuit de temporisation.

Le fonctionnement associé du dispositif de gestion est le même que celui déjà décrit en relation avec le premier ou le deuxième mode de réalisation de l'invention, à la différence que la durée de l'étape de positionnement va être rendue variable. Ainsi, si on a trois conducteurs de colonne (et donc trois constante de temps différentes) par circuit de temporisation, on applique trois fois la séquence d'étapes au même conducteur de ligne, en augmentant à chaque fois la durée d'application de l'information dans l'étape d'envoi : la première fois, on applique l'information pendant une durée Dt₁ qui permet, le cas échéant (touche enfoncée), la charge du condensateur uniquement par le premier conducteur, correspondant à la constante de temps la moins élevée; la deuxième fois, la durée d'application Dt₂ permet le cas échéant la charge du condensateur par l'un et/ou l'autre des deux premiers conducteurs de colonne; la troisième fois, la durée d'application Dt₃ permet la charge du condensateur par l'un et/ou l'autre des trois conducteurs de colonne. En effectuant et en mémorisant l'état des conducteurs de ligne dans chacune des étapes de lecture, on peut déterminer par discrimination l'état des différentes touches du conducteur de ligne concerné. On notera que pour chaque conducteur de colonne, il faut appliquer k fois la séquence d'étapes (ré-initialisation, positionnement et lecture), si k est le nombre de conducteurs de colonnes rattachés au même circuit de temporisation.

Si ce troisième mode de réalisation est combiné au deuxième mode de réalisation de l'invention, on applique la variation de la durée de la séquence de positionnement à chacune des deux séquences d'étapes.

En utilisant un tel dispositif de gestion selon ce troisième mode de réalisation, on peut gérer, à partir de n conducteurs de ligne, jusqu'à k.n² touches, voir plus, si on combine les deuxième et troisième mode de réalisation de l'invention. Ce sont les applications qui limitent les possibilités offertes par l'invention : limitation due à la vitesse de traitement-plus on a de conducteurs de colonne rattachés au même circuit de temporisation, plus le cycle de scrutation associé sera long : on multiplie par k ou plus le temps nécessaire à la scrutation d'un conducteur de ligne - et limitation due à l'espace supplémentaire à prévoir pour tous les circuits de ce dispositif de gestion.

L'utilisation de l'un ou l'autre mode de réalisation d'un dispositif de gestion selon l'invention dépend en pratique des contraintes et objectifs d'une application donnée.

Dans tous les modes de réalisation selon l'invention, le nombre de fils à gérer est égal au nombre n de conducteurs de lignes, pour un nombre de touches qui peut atteindre à x.n², où x est un entier supérieur ou égal à 1. On a ainsi pu gérer 52 touches au moyen de 3 conducteurs de ligne en utilisant le troisième mode de réalisation de l'invention avec des circuits de temporisation à mémoire.

En pratique, on prévoit une implantation uniforme pour tout le clavier. C'est à dire que l'on aura par exemple, dans le troisième mode de réalisation, trois conducteurs de colonne par circuit de temporisation pour tout le clavier, ou, dans le deuxième mode de réalisation, autant de circuits de temporisation dans chaque groupe.

Mais il n'est pas exclu pour autant que l'on n'ait pas cette uniformité en pratique, selon les besoins.

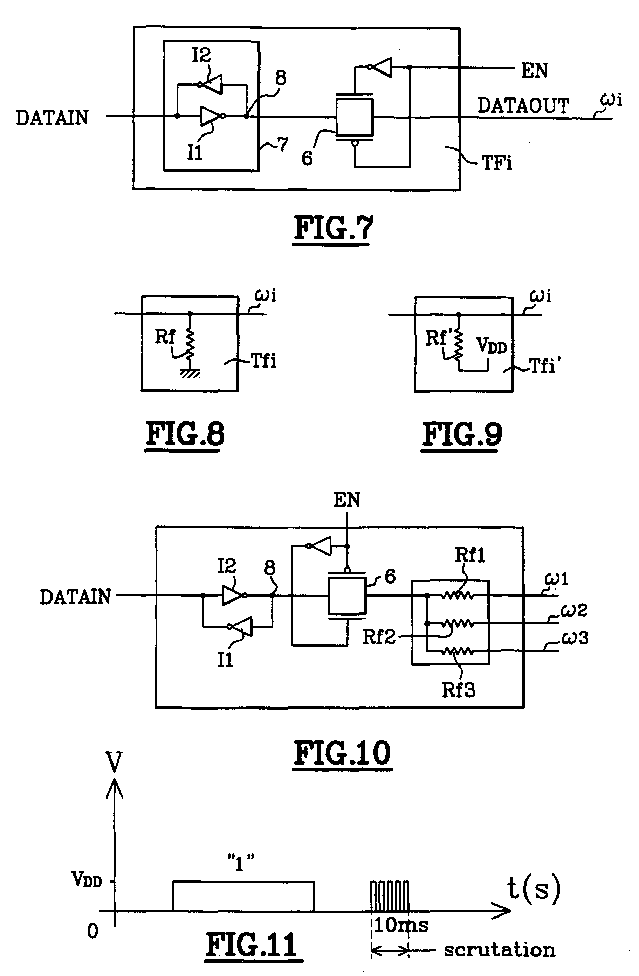

La figure 7 représente un exemple de réalisation d'un élément de tirage fort TFᵢ à une valeur "0" ou "1" qui peut-être utilisé dans un dispositif de gestion selon l'invention. Il est réalisé par un élément de registre. Cet élément de registre a une entrée de validation E, une entrée de donnée D 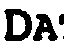 et une sortie D 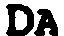 . Il comprend typiquement un élément de mémorisation 7 classiquement réalisé par deux inverseurs Il et I2 rebouclés en série entre l'entrée Det un noeud de sortie interne 8 et une porte de transfert 6 entre ce noeud de sortie interne et la sortie D. La porte de transfert 6 est commandée par l'entrée de validation E pour transmettre le niveau logique "0" ou "1" appliqué en entrée D sur la sortie D connectée à un conducteur de ligne wi associé. Quand cette entrée E n'est pas activée, la sortie D est en haute impédance. L'entrée de validation D est en pratique commandé par l'unité de commande (logique câblée avec horloge, par exemple).

Les figures 8 à 10 représentent des réalisations possibles des dispositifs de tirage faible utilisés dans l'invention.

Dans la figure 8, un élément de tirage faible à zéro Tfᵢ est représenté, simplement constitué d'une résistance R_{f} connectée entre un conducteur de ligne associé wi et la masse.

La figure 9 représente le schéma dual pour un élément de tirage faible à un Tf_{i'}, une résistance R_{f}' étant connectée à un potentiel positif, typiquement celui de la tension d'alimentation logique V.

La figure 10 représente un exemple de réalisation d'un élément dynamique de tirage faible à "1" ou à "0" T_{fi}". On peut donc l'activer ou le désactiver, et le commander pour tirer un conducteur de ligne wi associé soit à zéro, soit à un. Ceci est intéressant par rapport aux réalisations précédentes, car cela permet de diminuer la consommation du dispositif en n'activant les dispositifs de tirage faible que lorsque l'on en a besoin. Cette réalisation permet aussi d'avoir un seul dispositif de tirage faible par conducteur de ligne, ce qui est particulièrement intéressant dans le cadre de la mise en oeuvre du deuxième mode de réalisation d'un dispositif de gestion selon l'invention.

Dans l'exemple, cet élément de tirage faible comprend un élément de registre tel que décrit pour l'élément de tirage fort (figure 7), associé à une résistance R_{f1}. La sortie DATAOUT est connectée au conducteur de ligne wi à commander au travers de cette résistance. Dans une variante représentée sur la figure 10, cet élément de tirage faible comprend un réseau 9 de résistances comprenant dans l'exemple trois résistances R_{f1}, R_{f2} R_{f3}, chacune connectée entre la sortie DATAOUT et un conducteur de ligne respectif w1, w2 et w3. Cette variante permet de commander le tirage faible à "1" ou à "0" de plusieurs conducteurs de ligne en même temps. On peut ainsi réduire le nombre d'éléments de tirage faible nécessaires pour gérer l'ensemble des conducteurs de ligne du clavier.

En pratique, les différents éléments du dispositif de gestion peuvent être situés dans des équipements électroniques différents. De préférence, l'interface d'entrée/sortie 5 et les moyens de tirage 4 seront situés près du module central de commande. L'interface 5 peut-être une interface de ce module ou d'un micro-contrôleur commandé par ce module. Les circuits de temporisation d'information sont placés à proximité du clavier ou, de préférence, intégrés au clavier.

Avec un dispositif de gestion selon l'invention, le cycle de scrutation complet du clavier est très rapide, de l'ordre d'une centaine de microsecondes. Ce cycle peut se répéter à une fréquence moyenne assez lente, qui peut-être de l'ordre de dix millisecondes avec des circuits de temporisation à mémoire. En d'autres termes, et comme représenté sur la figure 11, si on suppose que ce cycle de scrutation est périodique, on a un cycle de scrutation de quelques centaines de microsecondes toutes les dix millisecondes environ.

Dans l'invention, on a prévu d'utiliser cette caractéristique pour commander, en dehors des cycles de scrutation, des éléments à commande d'entrée et/ou sortie lentes. On entend par "lentes" des entrées ou des sorties qui nécessitent un certain temps d'établissement pour leur commande en entrée ou en sortie.

Dans des systèmes électroniques complexes qui comprennent de nombreux équipements très différents contrôlés par un module central tel qu'un micro-ordinateur, un problème très important est en effet le nombre de fils à tirer d'un équipement à l'autre ou d'un équipement au module central de commande pour assurer l'ensemble des fonctionnalités requises. Un exemple typique concerne les systèmes électroniques embarqués dans les véhicules (voiture ou autres). Ces systèmes peuvent comprendre des équipements très divers tel qu'un clavier, différents capteurs (de température, de détection de la pluie,...) associés à des circuits correspondants (climatisation, voyants d'alarme, commande d'essuie-glace...). Certains de ces équipements sont à entrée et/ou sortie lentes.

Dans l'invention, on prévoit de gérer ces équipements au moyen du dispositif de gestion du clavier, en dehors des cycles de scrutation. Les signaux de gestion de ces entrées/sorties ont donc une fréquence beaucoup plus faible que les signaux de gestion du clavier comme représenté sur la figure 11 : la variation d'amplitude sur un conducteur de ligne wi est beaucoup plus rapide pendant le cycle de scrutation du clavier, dû à la succession des étapes de ré-initialisation, positionnement et lecture.

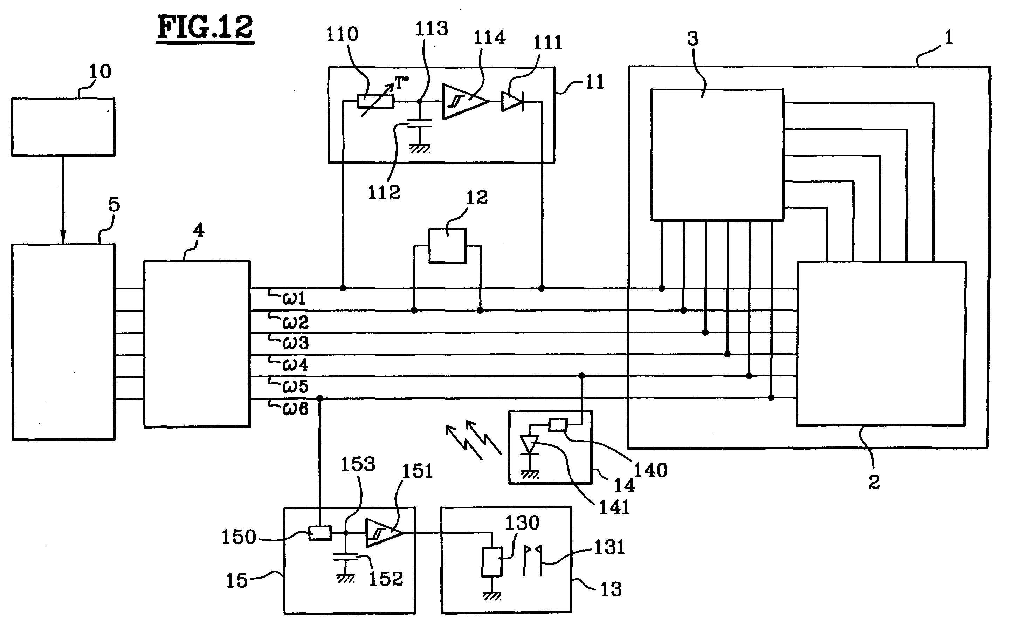

Un schéma-bloc d'un système complexe utilisant ce principe est représenté sur la figure 12.

Un module central de commande 10 commande l'interface d'entrée/sortie 5 par laquelle ce module va pouvoir gérer le clavier. On retrouve, comme sur la figure 1, les moyens de tirage 4, le clavier 1 avec sa matrice 2 et ses moyens de temporisation d'information 3, intégrés au clavier dans l'exemple.

Les conducteurs de ligne du clavier, w1 à w6 dans l'exemple sont tirés jusqu'aux moyens de tirage 4.

D'autres éléments électroniques sont connectés en entrée et/ou en sortie à ces conducteurs de ligne. Ces éléments peuvent être des capteurs, des voyants lumineux, ou autres, et peuvent être connectés à d'autres équipements électroniques non représentés. Dans l'exemple, on a représenté deux capteurs 11 et 12 connectés en entrée et en sortie à au moins un conducteur de ligne ; le capteur 11 est connecté en entrée IN sur le conducteur de ligne w1 tandis que sa sortie OUT est connectée sur le conducteur de ligne w2. Le capteur 12 est connecté en entrée IN et en sortie OUT sur le même conducteur de ligne w2. Ce sont des capteurs à entrée lente au sens de l'invention : pour effectuer la mesure en sortie du capteur, il faut attendre un certain temps après qu'une commande ait été appliquée en entrée du capteur.

Le capteur 11 est dans l'exemple un capteur de température qui comprend, entre l'entrée IN et la sortie OUT, une résistance thermique 110 suivi d'une diode 111 en direct et un condensateur 112 dont une électrode est connectée au point milieu 113 de connexion entre la résistance et la diode, et l'autre électrode à la masse. De préférence, et comme représenté, un trigger de Schmit 114 est placé devant la diode 111, entre le point milieu 113 et celle-ci.

Le principe de mesure est le suivant: on applique un "1" en entrée du capteur sur le conducteur de ligne w1. On mesure ensuite le temps au bout duquel on va retrouver ce 1 en sortie OUT du capteur, sur le conducteur de ligne w2. Ce temps, qui dépend de la constante de temps du capteur, et qui varie avec la valeur de la résistance thermique, donne la mesure de température. Pour effectuer cette mesure, on comprend que l'on peut utiliser les moyens de tirage 4 de manière appropriée pour appliquer la commande d'entrée et pour effectuer la lecture en sortie : dispositif de tirage fort pour imposer le "1" en entrée IN du capteur, dispositif de tirage faible à zéro pour tirer la sortie à zéro, et décompter le temps qu'il faut à cette sortie pour passer à "1".

Le trigger de Schmit 114, non obligatoire, permet d'améliorer la précision de la mesure.

Les variations très rapides de niveau sur les conducteurs de ligne pendant le cycle de scrutation sont sans conséquences pour le capteur de température.

On notera, comme représenté avec l'élément 12 sur la figure, que l'entrée et la sortie d'un capteur peuvent être connectées sur le même conducteur, moyennant un séquencement approprié des commandes sur cette ligne.

Bien que l'on ait représenté un capteur de température comme élément de commande d'entrée lente, l'homme du métier saura appliquer le principe de l'invention à tout autre élément à entrée lente au sens de l'invention.

Deux éléments à commande sortie lente sont représentés à titre d'exemple sur la figure 12 : un élément 13, de type relais, dont une entrée est commandée par le conducteur de ligne w6 et un élément 14, de type diode électroluminescente, dont une entrée est connectée au conducteur de ligne w5.

L'élément 13 comprend un relais formé d'une bobine 130 connectée entre la sortie I et la masse et d'un contact 131. Ce relais est un élément d'un équipement non représenté dans lequel il permet l'activation d'un circuit donné, comme par exemple un climatiseur. La sortie lente de cet élément, au sens de l'invention, est la commutation du relais : pour qu'elle se produise, il faut appliquer un niveau approprié en entrée pendant un temps suffisamment long devant le temps de réaction du relais. La commutation du relais peut ainsi être réalisée en appliquant pendant un temps suffisant un "1" sur le conducteur de ligne w6.

Pendant les cycles de scrutation, les variations de niveau très rapides sur le conducteur connecté en entrée du relais ne peuvent pas le faire commuter, mais elles peuvent provoquer le cliquetis du relais. Ce cliquetis peut être gênant dans certaines applications. Comme représenté sur la figure 12, on peut alors placer entre le conducteur w6 et l'entrée I du relais, un filtre 15 qui élimine les variations rapides d'amplitude en entrée du relais. De manière simplifiée, un tel filtre 15 peut comprendre une résistance 150 suivie d'un amplificateur de type trigger de Schmit 151 et un condensateur 152 dont une électrode est connectée au point milieu de connexion 153 entre la résistance et l'amplificateur et l'autre électrode à la masse.

L'autre élément à commande de sortie lente représenté est un circuit 14 de commande d'une diode électroluminescente, comprenant entre une entrée IN et la masse, une résistance 140 et la diode électroluminescente 141 elle-même. La sortie lente au sens de l'invention est l'allumage de la diode : le niveau haut d'activation de la diode doit rester appliqué en entrée pour que la diode soit allumée. Comme les cycles de scrutation du clavier sont très courts, si la diode est allumée, respectivement éteinte, avant le cycle, l'oeil d'un utilisateur ne percevra pas les extinctions intermittentes, respectivement les allumages intermittents, de la diode dus aux variations d'amplitude sur le conducteur de ligne w5 pendant le cycle de scrutation.

Dans un exemple d'application pratique à un système complexe utilisant un capteur de température, un relais et une diode électroluminescente, le module de commande peut ainsi surveiller cycliquement la température dans une application, et si un seuil est dépassé, commander un système de refroidissement en actionnant le relais et allumer un voyant d'alarme en commandant l'allumage de la diode électroluminescente. Tout ceci va se faire en séquence, par le dispositif de gestion, en dehors des cycles de scrutation.

L'invention qui vient d'être décrite peut être réalisée de nombreuses manières selon les besoins d'une application, en combinant les différents modes de réalisation. Toutes ces variantes sont du domaine de l'invention.

On a donné des exemples de réalisation et de mise en oeuvre des différents éléments du dispositif de gestion selon l'invention, en particulier, des circuits de temporisation à retard ou à mémoire. L'invention ne se limite pas à ces exemples. Notamment l'homme du métier peut choisir de réaliser les circuits de temporisation, de tirage ou autres de différentes manières, sans se départir de l'esprit de l'invention. De même, il peut appliquer l'invention à tout type d'éléments à commande d'entrée et/ou sortie lentes au sens de l'invention et sans se limiter aux exemples applicatifs qui ont été donnés ici.

## Revendications

1. Dispositif de gestion par n conducteurs de ligne d'un clavier à touches, ces touches étant chacune disposées à l'intersection d'un conducteur de ligne et d'un conducteur de colonne, caractérisé en ce qu'il comprend au moins un circuit de temporisation (32) d'une information par conducteur de ligne (w2), chacun connecté en entrée (I) à au moins un conducteur de colonne (c2) et en sortie (O) à un conducteur de ligne (w2), pour restituer sur le conducteur de ligne associé (w2), une information préalablement envoyée sur l'un des conducteurs de ligne (w1) lorsque la touche (T12) à l'intersection de ce dernier conducteur de ligne (w1) et du conducteur de colonne (c2) associé au-dit circuit de temporisation (32) est enfoncée.
Dispositif selon la revendication 1, caractérisé en ce qu'il comprend des moyens de commande (5) pour envoyer ladite information sur un conducteur de ligne puis lire tous les conducteurs de ligne, selon une séquence de balayage permettant de déterminer pour chaque conducteur de ligne, si une touche est enfoncée.
Dispositif de gestion selon la revendication 1 ou 2, caractérisé en ce qu'il comprend un seul circuit de temporisation (31) par conducteur de ligne (w1).
Dispositif de gestion selon la revendication 1 ou 2, caractérisé en ce qu'il comprend au moins deux circuits de temporisation (34a, 34b) d'informations différentes par conducteur de ligne (w1).
Dispositif de gestion selon la revendication 3 ou 4, caractérisé en ce que chaque circuit de temporisation (31) est connecté à un seul conducteur de colonne (c1).
Dispositif de gestion selon la revendication 3 ou 4, caractérisé en ce que chaque circuit de temporisation (37) est connecté à plusieurs conducteurs (c1, c2, c3) de colonne par des circuits de sélection fonction d'une caractéristique de l'information envoyée.
Dispositif selon l'une quelconque des revendications précédentes, caractérisé en ce que ladite information est une forme d'onde et lesdits circuits de temporisation sont des éléments à retard.
Dispositif selon la revendication 7, caractérisé on ce que les circuits de sélection selon la revendication 6 sont des filtres, avec une bande passante caractéristique par conducteur de colonne d'un circuit de temporisation.
Dispositif selon l'une quelconque des revendications précédentes, caractérisé en ce lesdits circuits de temporisation sont des circuits mémoire.
Dispositif selon la revendication 9, caractérisé on ce que les circuits de sélection selon la revendication 7 sont des résistances, avec une valeur de résistance caractéristique (R1, R2, R3) par conducteur de colonne (c1, c2, c3) d'un circuit de temporisation.
Dispositif selon la revendication 9 ou 10, caractérisé en ce qu'un circit de temporisation (31) comprend deux diodes en série (D1, D2) entre une borne d'entrée (I) et une borne de sortie (O) et un condensateur (C1) dont une électrode est connectée au point milieu (A) entre les deux diodes et l'autre électrode à la masse.
Dispositif selon l'une quelconque des revendications 9 à 11, caractérisé en ce qu'il comprend en outre des moyens de tirage (4) des conducteurs de ligne comprenant des éléments de tirage fort à "0" et à "1" (TFi) et des éléments de tirage faible à "0" et/ou à "1" (Tfi, Tfi',Tfi") activés selon une séquence de scrutation déterminée pour envoyer une information sur un conducteur de ligne et lire chacun des conducteurs de ligne en retour.
Dispositif selon l'une quelconque des revendications précédentes, caractérisé en ce que les circuits de temporisation (31) sont intégrés au clavier.
Dispositif de gestion selon l'une quelconque des revendications précédentes, caractérisé en ce qu'il comprend en plus du clavier, au moins un élément à commande d'entrée et/ou de sortie lentes (13) connecté en entrée et/ou en sortie auxdits conducteurs de ligne, ledit élément recevant en entrée et/ou fournissant en sortie des signaux de fréquence plus faible que les signaux de gestion dudit clavier.
Dispositif de gestion selon la revendication 14, caractérisé en ce qu'il comprend un filtre (15) connecté entre un conducteur de ligne (w6) et une entrée dudit élément (13) pour filtrer des variations d'amplitude de fréquence élevée sur ledit conducteur correspondant à des cycles de scrutation du clavier.
Dispositif de gestion selon la revendication 14, caractérisé en ce que ledit élément comprend un circuit de commande (14) d'une diode électroluminescente (141).
Dispositif de gestion selon la revendication 14 ou 15, caractérisé en ce que ledit élément comprend un circuit de commande de relais (13).
Dispositif de gestion selon la revendication 14, caractérisé en ce que ledit élément est un capteur de température (11).
